# EUROPÄISCHE PATENTANMELDUNG

(11) **EP 0 704 908 A2**
(43) Veröffentlichungstag der Anmeldung: **03.04.1996**
(21) Anmeldenummer: 95115099.4
(22) Anmeldetag: 25.09.1995
(51) Int. Cl.: H01L 29/745, H01L 29/08

(54) **Abschaltbares Halbleiterbauelement**

(30) Priorität: 30.09.1994 DE 4435079
(71) Anmelder: SIEMENS AKTIENGESELLSCHAFT, D-80333 München (DE)
(72) Erfinder: Schulze, Hans-Joachim, Dr., D-85521 Ottobrunn (DE)

(57) **Zusammenfassung**

Bei abschaltbaren Halbleiterbauelementen wie GTO-Thyristoren kann der Halbleiterkörper infolge von Inhomogenitäten beim Abschalten lokal überhitzt und zerstört werden. Der anodenseitige Emitter (4) ist daher mit zusätzlichen Stoffen dotiert, die oberhalb der Betriebstemperatur die Emitterdotierung lokal kompensieren und den Stromverstärkungsfaktor der anodenseitigen Transistorstruktur lokal herabsetzen. Damit wird ein erhöhter Abschaltstrom erreicht.

## Beschreibung

Die Erfindung bezieht sich auf ein abschaltbares Halbleiterbauelement mit einem Halbleiterkörper mit mindestens einer ersten Emitterzone vom ersten Leitungstyp, mindestens einer an die erste Emitterzone angrenzenden Basiszone vom zweiten Leitungstyp, einer an die Basiszone angrenzenden Innenzone vom ersten Leitungstyp und mindestens einer an die Innenzone angrenzenden zweiten Emitterzone vom zweiten Leitungstyp, die eine gegebene Dotierungskonzentration von ersten Stoffen hat.

Beim Abschalten von Halbleiterbauelementen der angegebenen Art, wie z.B. GTO-Thyristoren oder IGBT, können aufgrund von Inhomogenitäten Bereiche mit erhöhter Stromdichte, sogenannte Filamente auftreten. Wird die Stromdichte sehr hoch, kann der Halbleiterkorper durch Überhitzung zerstört werden.

Ziel der Erfindung ist es, ein abschaltbares Halbleiterbauelement der genannten Art so weiterzubilden, daß die im Halbleiterkörper vorhandenen Inhomogenitäten beim Abschalten keine lokal wesentlich erhöhte Stromdichte verursachen.

Dieses Ziel wird dadurch erreicht, daß mindestens die zweite Emitterzone mit zusätzlichen Stoffen dotiert ist, die oberhalb der Betriebstemperatur des Halbleiterbauelementes als Dotierstoffe des ersten Leitungstyps wirken.

Weiterbildungen der Erfindung sind Gegenstand der Unteransprüche.

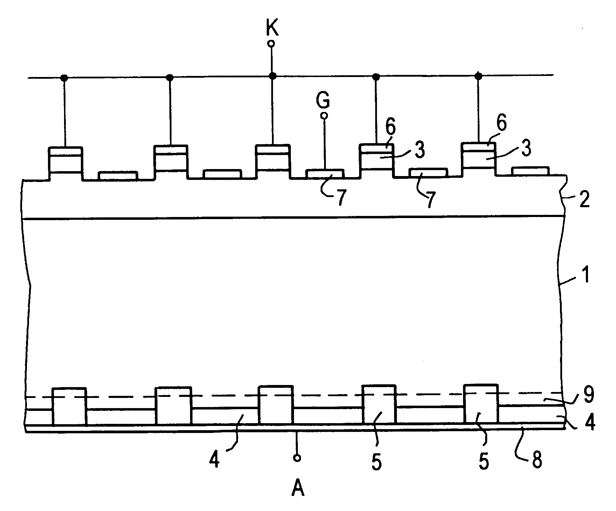

Die Erfindung wird anhand eines Ausführungsbeispiels anhand der Figur erläutert. Diese Figur stellt einen Schnitt durch den Halbleiterkörper eines GTO-Thyristors dar.

Der Halbleiterkörper des GTO-Thyristors nach der Figur hat eine Innenzone 1 vom ersten Leitungstyp. An die Innenzone 1 schließt sich eine Basiszone 2 vom zweiten Leitungstyp an. An die Basiszone 2 grenzen erste Emitterzonen 3, die vom gleichen Leitungstyp wie die Innenzone sind, jedoch wesentlich höher dotiert sind als diese. Auf der der Basiszone 2 gegenüberliegenden Seite liegt eine zweite Emitterzone 4, die wieder vom zweiten Leitungstyp ist. Die zweite Emitterzone 4 ist von Kurzschlußzonen 5 durchbrochen, die den gleichen Leitungstyp wie die Innenzone 1, jedoch höhere Dotierung als diese haben. Die Kurzschlußzonen 5 haben üblicherweise eine größere Tiefe als die zweite Emitterzone 4.

Die ersten Emitterzonen 3 sind mit Emitterelektroden 6 verbunden, die einander parallel geschaltet sind. Die zweiten Emitterzonen und die Kurzschlußzonen 5 sind mit einer Elektrode 8 verbunden. Die Basiszone 2 ist mit einer Steuerelektrode 7 kontaktiert. Sie ist mit einem Steueranschluß G verbunden. Üblicherweise ist bei einem GTO-Thyristor die Zonenfolge von den ersten Emitterzonen 3 bis zur zweiten Emitterzone 4 npnp. Damit bilden die Elektroden 6 den Katodenanschluß K und die Elektrode 8 den Anodenanschluß A.

Wird ein solcher GTO-Thyristor aus dem leitenden Zustand heraus abgeschaltet, so können sich aufgrund der eingangs erwähnten unvermeidbaren Inhomogenitäten im Halbleiterkörper die genannten Stromfilamente ausbilden, in denen die Stromdichte lokal erheblich höher als im übrigen Teil des Halbleiterkörpers ist. Die Stromdichte kann dort so hoch werden, daß der Halbleiterkörper aufschmilzt. Zur Vermeidung dieser Stromfilamente wird nun mindestens der zweite Emitter 4 zusätzlich zu den üblichen Dotierstofffen des zweiten Leitungstyps wie z.B. Bor mit zusätzlichen Stoffen dotiert. Diese Dotierstoffe werden so ausgewählt, daß sie oberhalb der Betriebstemperatur, also bei 300 °C und höher als Dotierstoffe des ersten Leitungstyps wirken, während sie bei der normalen Betriebstemperatur nur zu einem relativ geringen

Anteil elektrisch aktiv sind. Für den üblichen Fall, daß die zweite Emitterzone p-dotiert ist, müssen diese zusätzlichen Stoffe bei 300° C also Donatoreigenschaften haben. Als zusätzliche Stoffe mit derartigen Donatoreigenschaften kommen z.B. Molybdän, Niob, Cäsium oder Barium in Frage. Für den Fall, daß die umgekehrte Zonenfolge vorliegt und der zweite Emitter 4 n-dotiert ist, müssen die zusätzlichen Stoffe oberhalb der Betriebstemperatur Akzeptoreigenschaften haben. Hierfür geeignete Stoffe sind z.B. Cadmium, Zink, Gold, Nickel.

Den genannten Stoffen ist gemeinsam, daß sie oberhalb der Betriebstemperatur, also bei etwa 300 °C und höher, die Dotierung der Emitterzone 4 je nach Dotierungskonzentration der ersten Stoffe teilweise oder gänzlich kompensieren. Für eine vollständige Kompensation der in der zweiten Emitterzone 4 vorhandenen ersten Dotierstoffe sollte die Dotierungskonzentration der zusätzlichen Stoffe so hoch sein wie die der ersten Stoffe.

Die zusätzlichen Stoffen wirken also dann kompensierend, wenn sich die erwähnten Stromfilamente ausbilden und die Temperatur in diesen ansteigt. In den Stromfilamenten wird daher lokal der Emitterwirkungsgrad des aus den Zonen 2, 1 und 4 bestehenden anodenseitigen Teiltransistors herabgesetzt. Der Herabsetzung des Stromverstärkungsfaktors entspricht eine Herabsetzung des beim Abschalten fließenden Stroms in diesen Filamenten, so daß der Abschaltstrom insgesamt vergleichmäßigt wird.

Die zusätzlichen Stoffe können auch über den zweiten Emitter hinaus in den angrenzenden Bereich der Innenzone 1 eingebracht werden. Sie sollten jedoch nicht tiefer eingebracht werden als die Tiefe der Kurzschlüsse 5 beträgt, d.h. also z.B. bis zu einer Tiefe, die durch die gestrichelte Linie 9 veranschaulicht ist. In dem an die zweite Emitterzone 4 angrenzenden Bereich der Innenzone 1 wirken die zusätzlichen Stoffe bei Temperaturerhöhung in den Filamenten wie eine Erhöhung der Dotierung. Da die Stromverstärkung vom Verhältnis der Dotierstoffkonzentration beiderseits des pn-Übergangs abhängt, bewirkt die Anhebung der Dotierungskonzentration in dem genannten Bereich der Innenzone 1 und die Absenkung der effektiven Dotierungskonzentration in der Zone 4 innerhalb der Stromfilamente insgesamt eine Verringerung des Stromverstärkungsfaktors. Dadurch kann der anodenseitige Stromverstärkungsfaktor in den Filamenten bis auf Null abgesenkt werden. Damit verschwinden die Filamente, die Temperatur sinkt und der anodenseitige Stromverstärkungsfaktor kann wieder ansteigen, bis sich ein Gleichgewicht einstellt. In diesem Zustand fließt dann ein im wesentlichen homogener Abschaltstrom zur Steuerelektrode 7.

Der übrige Bereich der Innenzone 1, die Basiszone 2 und die erste Emitterzone 3 bleiben frei von den zusätzlichen Stoffen. Eine Dotierung der Kurzschlußzonen 5 mit den zusätzlichen Stoffen beeinträchtigt deren Wirkung nicht.

## Patentansprüche

1. Abschaltbares Halbleiterbauelement mit einem Halbleiterkörper mit mindestens einer ersten Emitterzone (3) vom ersten Leitungstyp, mindestens einer an die erste Emitterzone angrenzenden Basiszone (2) vom zweiten Leitungstyp, einer an die Basiszone angrenzenden Innenzone (1) vom ersten Leitungstyp und mindestens einer an die Innenzone angrenzenden zweiten Emitterzone (4) vom zweiten Leitungstyp, die eine gegebene Dotierungskonzentration von ersten Stoffen hat,
**dadurch gekennzeichnet,** daß mindestens die zweite Emitterzone (4) mit zusätzlichen Stoffen dotiert ist, die oberhalb der Betriebstemperatur des Halbleiterbauelementes als Dotierstoffe des ersten Leitungstyps wirken.

2. Halbleiterbauelement nach Anspruch 1,
**dadurch gekennzeichnet,** daß die zweite Emitterzone (4) p-dotiert ist und daß die zusätzlichen Stoffe oberhalb der Betriebstemperatur Donatoreigenschaften haben.

3. Halbleiterbauelement nach Anspruch 2,
**dadurch gekennzeichnet,** daß die zusätzlichen Stoffe Molybdän, Niob, Cäsium, Barium sind.

4. Halbleiterbauelement nach Anspruch 1,
**dadurch gekennzeichnet,** daß die zweite Emitterzone n-dotiert ist und daß die zusätzlichen Stoffe oberhalb der Betriebstemperatur Akzeptoreigenschaften haben.

5. Halbleiterbauelement nach Anspruch 4,
**dadurch gekennzeichnet,** daß die zusätzlichen Stoffe Cadmium, Zink, Gold, Nickel sind.

6. Halbleiterbauelement nach einem der Ansprüche 1 bis 5,
**dadurch gekennzeichnet,** daß auch die Innenzone (1) auf derjenigen Seite mit den zusätzlichen Stoffen dotiert ist, die an die zweite Emitterzone (4) angrenzt.

7. Halbleiterbauelement nach Anspruch 6,
**dadurch gekennzeichnet,** daß auf der Seite der zweiten Emitterzone (4) an die Oberfläche des Halbleiterkörpers reichende Kurzschlußzonen (5) angeordnet sind, die den der zweiten Emitterzone (4) entgegengesetzten Leitungstyp und eine vorgegebenen Tiefe haben, und daß die Innenzone (1) bis zu einer Tiefe mit den zusätzlichen Stoffen dotiert ist, die kleiner ist als die vorgegebene Tiefe.

8. Halbleiterbauelement nach einem der Ansprüche 1 bis 7,
**dadurch gekennzeichnet,** daß die Dotierungskonzentration der zusätzlichen Stoffe mindestens gleich der Dotierungskonzentration der ersten Stoffe ist.
